# FASCICULE DE BREVET EUROPEEN

(11) **EP 1 150 550 B1**
(45) Date de publication et mention de la délivrance du brevet: **11.02.2009**
(21) Numéro de dépôt: 01460030.8
(22) Date de dépôt: 26.04.2001
(51) Int. Cl.: H05K 1/00

(54) **Procédé pour interconnecter des composants électroniques dans un objet portable se présentant sous la forme d'une carte de crédit**
Verfahren zur Verbindung von elektronischen Bausteinen in einer kreditkartenartigen tragbaren Vorrichtung
Method for interconnecting electronic components in a portable credit card-like device

(30) Priorité: 26.04.2000 FR 0005348
(43) Date de publication de la demande: 31.10.2001
(73) Titulaire: Audiosmartcard International S.A., 75008 Paris (FR)
(72) Inventeur: Moulin, Jean, 91260 Juvisy (FR); Gayet, Alain, 92400 Courbevoie (FR)
(74) Mandataire: Schmit, Christian Norbert Marie

(56) Documents cités:
- EP-A- 0 488 574
- WO-A-92/20048
- US-A- 4 995 077

## Description

Le domaine technique concerné par la présente invention est celui de la réalisation des interconnexions entre les composants électroniques contenus dans des objets nomades de petite taille.

Il est connu des objets nomades de petite taille. De tels objets nomades ont notamment été décrits dans le brevet n° 9306679 du vingt neuf septembre mille neuf cent quatre vingt quinze et ayant pour titre "Dispositif de composition automatique de numéros de téléphone". L'objet nomade décrit dans ce brevet permet à son possesseur de s'identifier de manière sûre et protégée auprès d'un système informatique interrogé à distance. Pour ce faire, l'objet nomade est capable de mémoriser un numéro de téléphone et de le composer par synthèse de fréquence vocale.

Un objet nomade similaire est également connu du brevet WO 92/200 48.

La production en grande série d'un objet nomade suppose de concilier simultanément une cadence de production élevée, un coût de revient faible et une très haute fiabilité. Ces trois paramètres sont le plus souvent dépendants du nombre de composants équipant ledit objet nomade et du nombre d'interconnexions qu'ils induisent. Lorsqu'ils se présentent sous la forme d'une carte de crédit, les objets nomades génèrent au surplus des contraintes physiques de format (carte de crédit) et d'épaisseur (0,8mm).

S'agissant particulièrement de la réalisation des interconnexions au sein d'un objet nomade ayant la forme d'une carte, on constate que deux couches topologiques d'interconnexions sont nécessaires pour interconnecter entre eux les composants électroniques de la carte. Selon l'art antérieur, pour satisfaire cette contrainte, on utilise un circuit imprimé à deux couches comprenant des trous métallisés, ce qui permet de réaliser les connexions entre les différents composants de la carte.

Un progrès, en terme de coût, a pu être réalisé grâce à l'utilisation de circuits imprimés largement operculés ne comportant qu'une seule couche d'interconnexions avec les composants de l'une des faces. Les composants de l'autre face sont connectés par des liaisons électriques passant par l'opercule. Malgré cette amélioration, le coût de fabrication du support et le coût de la main d'oeuvre représentent encore, selon le type de carte, entre 15% et 40% du coût total de la carte.

On constate par ailleurs que les objets nomades, au format carte de crédit, comportent toujours deux coques destinées à protéger le corps de la carte sur lequel sont montés les composants électroniques. Ces coques sont d'ailleurs utilisées comme supports de communication. On peut en effet imprimer des messages visuels sous forme d'images. Or, il est connu que dans un contexte de production de cartes en continu, le coût d'impression d'une couche supplémentaire sur une coque est marginal.

L'invention consiste donc à supprimer le circuit imprimé d'interconnexions au profit de l'utilisation des coques avant et arrière de la carte, sur lesquelles on imprime une couche supplémentaire. En l'occurence, cette couche supplémentaire est une couche conductrice remplissant les mêmes fonctions que le circuit imprimé. Ainsi, l'invention permet de réduire sensiblement le coût de fabrication des objets nomades au format carte de crédit.

L'invention s'applique à un objet électronique nomade se présentant notamment sous la forme d'une carte de crédit. Il comprend deux coques entre lesquelles sont insérés des composants électroniques comportant des plots de contact électrique.

L'invention concerne un procédé pour réaliser, dans cet objet électronique nomade, les interconnexions entre les composants électroniques contenus par l'objet nomade.

Le procédé, selon l'invention, comprend l'étape d'imprimer une couche conductrice sur la face interne d'au moins une des coques, au moins à l'emplacement des connexions à établir entre lesdits composants électroniques.

Le procédé, selon l'invention, comprend en outre l'étape d'appliquer les couches conductrices desdites coques sur les plots de contact électrique des composants électroniques, notamment par collage conducteur et/ou par soudure et/ou par brasure et/ou par pression.

Ainsi, des contacts galvaniques sont réalisés entre les composants électroniques.

Dans le cas où les composants électroniques comportent des plots de contact électrique sur chacune de leur face, de préférence le procédé comprend l'étape d'imprimer une couche conductrice sur les faces de chacune des deux coques entre lesquelles sont insérés lesdits composants électroniques.

Dans ce même cas, le procédé comprend en outre l'étape d'insérer des éléments intercalaires conducteurs entre les couches conductrices imprimées sur chacune des faces internes des deux coques.

Ainsi, on peut établir des liaisons électriques entre les plots de contact situés sur l'une et/ou l'autre des faces des composants électriques.

Avantageusement, le procédé s'applique à la réalisation d'une carte émettrice de signaux telle que décrite dans le brevet n° 9306679, ci-dessus mentionné. La carte émettrice de signaux comporte au moins les composants suivants: une pile, un microprocesseur, un émetteur de signaux. La pile et l'émetteur de signaux sont interconnectés au microprocesseur.

De préférence, la carte émettrice de signaux comporte en outre un microphone interconnecté au microprocesseur.

De préférence, la carte comporte en outre une entrée hertzienne, notamment une antenne, interconnectée au microprocesseur.

De préférence, la carte comporte en outre un contact à coupelle métallique interconnecté au microprocesseur.

L'invention concerne également un objet électronique nomade se présentant sous la forme d'une carte de crédit.

Cet objet électronique nomade comprend des composants électroniques comportant des plots de contact électrique.

Il comprend en outre deux coques entre lesquelles sont insérés lesdits composants électroniques.

Il comprend en outre une couche conductrice imprimée sur la face interne d'au moins une des coques, au moins à l'emplacement des connexions à établir entre les composants électroniques.

La couche conductrice de la coque est appliquée sur les plots de contact électrique des composants électroniques, notamment par collage conducteur et/ou par soudure et/ou par brasure et/ou par pression.

Ainsi, des contacts galvaniques sont réalisés entre les composants électroniques.

Dans le cas où les composants électroniques comportent des plots de contact électrique sur chacune de leur face, de préférence l'objet nomade comprend deux couches conductrices imprimées sur les faces internes de chacune des deux coques entre lesquelles sont insérées lesdits composants électroniques.

Dans ce même cas, l'objet nomade comprend en outre des éléments intercalaires conducteurs insérés entre les deux couches conductrices. Ainsi, on peut établir des liaisons électriques entre les plots de contact situés sur l'une et/ou l'autre des faces des composants électriques.

Selon une variante de réalisation de l'invention, l'objet électronique nomade se présente sous la forme d'une carte émettrice de signaux acoustiques. La carte comporte au moins les composants suivants : une pile, un microprocesseur, un émetteur de signaux. La pile et l'émetteur de signaux sont interconnectés au microprocesseur via la ou les couches imprimées conductrices.

De préférence, selon cette variante de réalisation de l'invention, la carte comporte en outre un microphone interconnecté au microprocesseur via la ou les couches imprimées conductrices.

De préférence, selon cette variante de réalisation de l'invention, la carte comporte en outre une entrée hertzienne, notamment une antenne, interconnectée au microprocesseur, via la ou les couches imprimées conductrices.

De préférence, selon cette variante de réalisation de l'invention, la carte comporte en outre un contact à coupelle métallique interconnecté au microprocesseur via la ou les couches imprimées conductrices.

D'autres caractéristiques et avantages de l'invention apparaîtront à la lecture de la description de variantes de réalisation de l'invention, données à titre d'exemple indicatif et non limitatif, et de :
la figure 1 présentant une vue en coupe d'un objet électronique nomade, selon l'art antérieur. Il comporte un circuit imprimé comprenant deux couches topologiques d'interconnexions,
la figure 2 présentant une vue en coupe d'un objet électronique nomade, selon l'art antérieur. Il comporte un circuit imprimé, largement operculé, ne comprenant qu'une seule couche d'interconnexions,
la figure 3 présentant une vue en coupe d'un objet électronique nomade au sens la présente invention. Le circuit imprimé a disparu. Les couches d'interconnexions sont imprimées directement sur les coques de l'objet nomade,
la figure 4 présentant une vue en coupe de la structure des coques de l'objet électronique nomade au sens la présente invention.

On va maintenant décrire les figures.

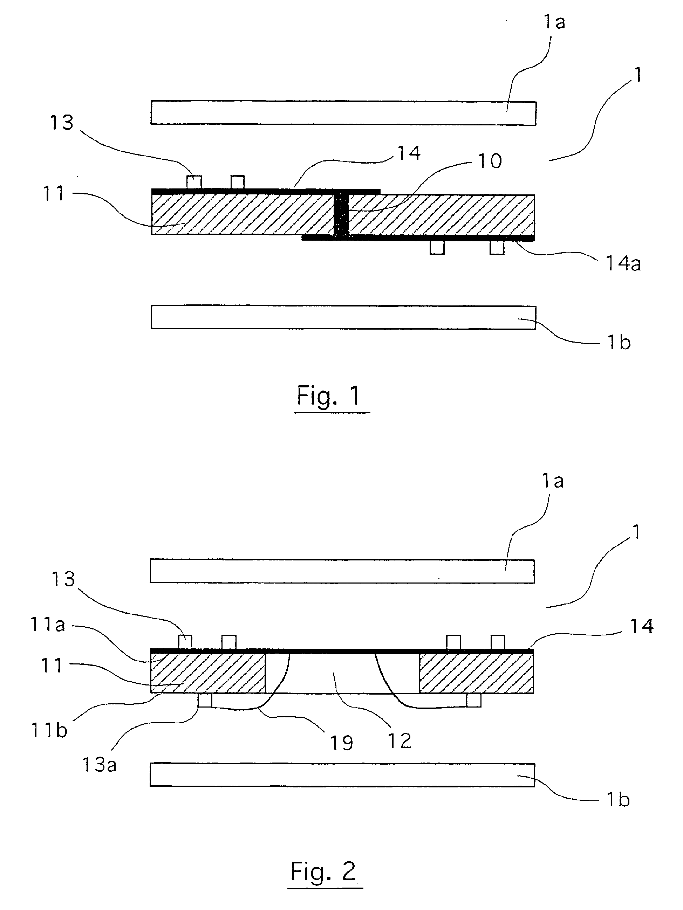

La figure 1 présente une vue en coupe d'un premier objet électronique nomade 1, selon l'art antérieur. Entre les deux coques 1a, 1b de l'objet électronique nomade 1, on trouve un corps isolant 11 et deux couches d'interconnexions 14, 14a. Les composants électroniques 13 de l'objet électronique nomade 1 sont collés et/ou soudés sur les couches d'interconnexions 14, 14a. Des trous métallisés 10 permettent d'établir une interconnexion entre les deux couches d'interconnexions 14, 14a.

La figure 2 présente une vue en coupe d'un second objet électronique nomade 1, toujours selon l'art antérieur. Entre les deux coques 1a, 1b de l'objet électronique nomade 1, on retrouve un corps isolant 11. Ce corps isolant comporte un large opercule 12 en lieu et place des trous métallisés 10. Ainsi, une seule couche d'interconnexions 14 suffit pour interconnecter les composants électroniques 13 contenus dans l'objet électronique nomade 1. Des liaisons électriques 19, traversant l'opercule 12 permettent de connecter les composants électroniques 13a, situés sur la face 11b du corps isolant 11, à la couche d'interconnexions 14.

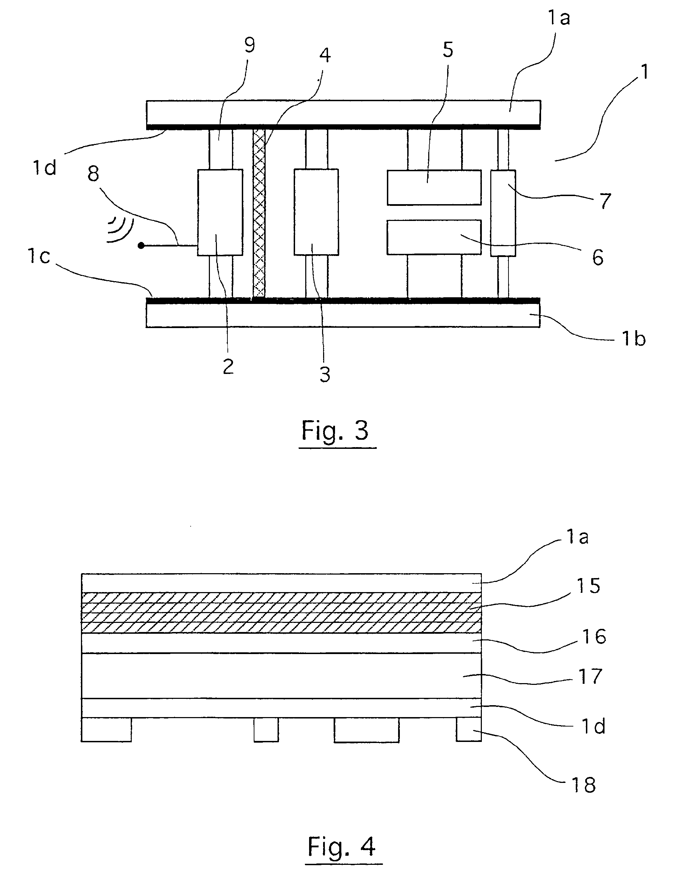

Sur la figure 3, on a représenté un objet électronique nomade 1 au sens de l'invention. Il se présente sous la forme d'une carte émettrice de signaux acoustiques. Cet objet électronique nomade 1 comporte deux coques 1a, 1b. Entre ces deux coques 1a, 1b, sont insérés des composants électroniques 2, 3, 5, 6, 7, 8. Au nombre de ces composants, on trouve: un microprocesseur 2, une pile 3, un émetteur de signaux 5, un microphone 6, un contact à coupelle métallique 7, ainsi qu'une antenne hertzienne 8. Ces composants électroniques 2, 3, 5, 6, 7, 8 comportent des plots de contact électrique 9 sur chacune de leurs faces.

La figure 4 représente la structure des coques 1a, 1b. Elles sont réalisées de manière identique dans un matériau transparent, notamment du polycarbonate, résistant aux rayures. Sur la face interne de la coque 1a sont imprimées successivement plusieurs couches : quatre couches de couleur 15, une couche de blanc réfléchissant 16 destinée à réfléchir les couches de couleur 15, une couche de gris opacifiant 17 destinée à rendre la coque opaque aux objets situés en dessous d'elle et une couche conductrice 1d, permettant d'interconnecter les composants électroniques 8, 2, 3, 5, 6, 7, entre eux. Une couche isolante 18 est enfin rajoutée à l'emplacement de certaines zones afin de les isoler. En effet, il peut être utile dans certaines configurations topologiques, d'isoler la couche conductrice 1d afin d'éviter des courts-circuits indésirables avec des parties conductrices des composants électroniques 8, 2, 3, 5, 6, 7.

Sur la face interne de la coque 1b, on retrouve un empilement de couches similaire, notamment une autre couche conductrice 1c.

Les couches conductrices 1d, 1c, de chacune des faces internes 1a et 1b, sont appliquées sur les plots de contact électrique 9 des composants électroniques 8, 2, 3, 5, 6, 7, notamment par collage conducteur et/ou par soudure et/ou par brasure et/ou par pression. La pile 3 peut ainsi alimenter en énergie les composants électroniques 8, 2, 5, 6, 7.

Entre les couches conductrices 1d, 1c, sont insérés des éléments intercalaires 4 conducteurs, en contact avec les couches conductrices 1d, 1c. Ces éléments intercalaires 4 permettent de réaliser des liaisons électriques entre les plots de contact 9 situés sur les faces opposées des composants électroniques 8, 2, 3, 5, 6, 7. Les couches conductrices 1d, 1c permettent de réaliser des contacts galvaniques entre les composants électroniques 8, 2, 3, 5, 6, 7 contenus dans l'objet électronique nomade 1. Ainsi, via les couches conductrices 1d, 1c, la pile 3, l'émetteur de signaux 5, le microphone 6, l'antenne 8 et le contact à coupelle métallique 7 sont interconnectés au microprocesseur 2.

## Revendications

1. Procédé pour réaliser, dans un objet électronique nomade (1) se présentant sous la forme d'une carte de crédit, les interconnexions entre des composants électroniques (2, 3, 5, 6, 7, 8) contenus dans ledit objet nomade (1);
ledit objet électronique nomade (1) comprenant deux coques (1a, 1 b) entre lesquelles sont insérés lesdits composants électroniques (2, 3, 5, 6, 7, 8) comportant des plots (9) de contact électrique sur chacune de leur faces ;
ledit procédé comprenant les étapes suivantes :
- l'étape d'imprimer une couche conductrice (1 c, 1 d) sur la face interne de chacune des deux coques (1a, 1 b), au moins à l'emplacement des connexions à établir entre lesdits composants électroniques (2, 3, 5, 6, 7, 8),
- l'étape d'appliquer les couches conductrices (1d, 1c) desdites coques (1a, 1 b) sur les plots (9) de contact électrique des composants électroniques (2, 3, 5, 6, 7, 8), notamment par collage conducteur ou par soudure ou par brasure ou par pression,
- l'étape d'insérer des éléments intercalaires (4) conducteurs entre les couches conductrices (1d, 1c) imprimées sur chacune des faces internes des deux coques (1a, 1 b),

2. Procédé selon la revendication 1; ladite carte comportant au moins les composants suivants :
- une pile (3),
- un microprocesseur (2),
- un émetteur de signaux (5),
ladite pile (3) et ledit émetteur de signaux (5) étant interconnectés audit microprocesseur (2).

3. Procédé selon la revendication 2; ladite carte comportant en outre :
- un microphone (6) interconnecté au microprocesseur (2).

4. Procédé selon l'une quelconque des revendications 2 ou 3 ; ladite carte comportant en outre :
- une entrée hertzienne, notamment une antenne (8), interconnectée au microprocesseur (2).

5. Procédé selon l'une quelconque des revendications 2 à 4 ; ladite carte comportant en outre :
- un contact à coupelle métallique (7) interconnecté au microprocesseur (2).

6. Objet électronique nomade (1) se présentant sous la forme d'une carte de crédit ; ledit objet électronique nomade comprenant :
- des composants électroniques (2, 3, 5, 6, 7, 8) comportant des plots (9) de contact électrique sur chacune de leur face,
- deux coques (1a, 1b) entre lesquelles sont insérés lesdits composants électroniques (2, 3, 5, 6, 7, 8),
- une couche conductrice (1c, 1d) imprimée sur les faces internes des deux coques (1a, 1 b), au moins à l'emplacement des connexions à établir entre lesdits composants électroniques (2, 3, 5, 6, 7, 8) ;
- lesdites couches conductrices (1 c, 1d) desdites coques (1a, 1b) étant appliquées sur les plots (9) de contact électrique des composants électroniques (2, 3, 5, 6, 7, 8), notamment par collage conducteur ou par soudure ou par brasure ou par pression,
- des éléments intercalaires (4) conducteurs insérés entre les deux couches conductrices (1 d, 1 c),

7. Objet électronique nomade (1) selon la revendication 6 se présentant sous la forme d'une carte émettrice de signaux acoustiques ; ladite carte comportant au moins les composants suivants :
- une pile (3),
- un microprocesseur (2),
- un émetteur de signaux (5),
ladite pile (3) et ledit émetteur de signaux (5) étant interconnectés audit microprocesseur (2) via ladite ou lesdites couches imprimées conductrices (1d, 1c).

8. Objet électronique nomade (1) selon la revendication 7 ; ladite carte comportant en outre un microphone (6) interconnecté au microprocesseur (2) via ladite ou lesdites couches imprimées conductrices (1 d, 1 c).

9. Objet électronique nomade (1) selon l'une quelconque des revendications 7 ou 8; ladite carte comportant en outre :
- une entrée hertzienne, notamment une antenne (8), interconnectée au microprocesseur (2).

10. Objet électronique nomade (1) selon l'une quelconque des revendications 7 à 9 ; ladite carte comportant en outre un contact à coupelle métallique (7) interconnecté au microprocesseur (2) via ladite ou lesdites couches imprimées conductrices (1d, 1 c).

## Claims

1. The process for realizing, within a mobile electronic object (1) presented in the form of a credit card, the interconnections between the electronic components (2,3,5,6,7,8) being contained in the said mobile object(1):
the said electronic mobile object (1) comprising two casings(1a,1b) between which the said electronic components (2,3,5,6,7,8)are inserted, including electronic contact studs (9) on each of their surfaces;
the said process is made up of the following steps:
- the step of printing a circuit layer (1c,1d) on the internal surfaces of the two casings (1a, 1b), at least up to where the connections to be established between the said electronic components (2,3,5,6,7,8) will be placed.
- the step of applying the circuit layers (1d,1c)of the said casings (1a,1b)on the electronic contact studs (9)of the electronic components (2,3,5,6,7,8) in particular using conductive adhesive or by solder, or by welding, or by pressure,
- the step of inserting conductive dividers (4) between the circuit layers(1d,1c) printed on each internal surface of the two casings(1a,1b).

2. The process according to claim 1; the said card comprising at least the following components:
- a battery (3),
- a microprocessor (2),
- a signal sender (5),
the said battery (3) and the said signal sender (5)being interconnected to the said microprocessor(2).

3. The process according to claim 2; the said card comprising among other things:
- a microphone (6) interconnected to the said microprocessor (2).

4. The process according to either one of claims 2 or 3; the said card furthermore comprising :
- a terrestrial input, particularly an antenna (8) interconnected to the microprocessor (2).

5. The process according to any one of claims 2 to 4; the said card comprising among other things:
- a contact to a metal cap (7) interconnected to the microprocessor (2).

6. The mobile electronic object (1) being in the form of a credit card:
the said mobile electronic object comprising:
- electronic components(2,3,5,6,7,8)and electric contact studs (9) on each of their surfaces,
- two casings (1a, 1b)between which are inserted the said electronic components (2, 3, 5, 6, 7, 8),
- a circuit layer (1c, 1d) printed on the internal surfaces of the two casings (1a,1b), at least up to where the connections to be established between the said electronic components (2,3,5,6,7, 8), will be placed;
- the said circuit layers (1c, 1d) of the said casings (1a, 1b) being applied to the said electronic contact studs (9) of the electronic components (2, 3, 5, 6, 7, 8), in particular by conductive glue, by solder, by welding or by pressure,
- conductive dividers (4) inserted between the circuit layers (1c, 1d),

7. The mobile electronic object (1) according to claim 6 is shown in the form of a card sending acoustic signals; the said card comprises the following components at least:
- a battery(3),
- a microprocessor(2),
- a signal sender(5), the said battery (3) and the said sender of signals (5) being interconnected to the said microprocessor (2) via the said printed circuit layers (1d,1c).

8. The mobile electronic object (1) according to claim 7; the said card furthermore comprising a microphone (6) interconnected to the microprocessor (2) via the said printed circuit layer/s (1d,1c).

9. The mobile electronic object (1) according to either of claims 7 or 8; the said card comprising among other things:
- a terrestrial input, in particular an antenna(8) interconnected to the microprocessor (2).

10. The mobile electronic object (1) according to either of claims 7 to 9; the said card comprising among other things a contact to a metal cap (7) interconnected to the microprocessor (2) via the said printed circuit layers (1d,1c).

## Patentansprüche

1. Verfahren zum Erstellen der Verbindungen zwischen elektronischen Bauteilen (2, 3, 5, 6, 7, 8) in einem mobilen elektronischen Gegenstand (1) in Form einer Kreditkarte, die eben in dem besagten mobilen Gegenstand (1) enthalten sind;
wobei der besagte mobile elektronische Gegenstand (1) zwei Gehäuseschalen (1a, 1b) enthält, zwischen denen die besagten elektronischen Bauteile (2, 3, 5, 6, 7, 8) eingebettet sind, die jeweils auf beiden Seiten elektrische Kontaktlötstellen (9) enthalten;
wobei das besagte Verfahren folgende Schritte enthält:
- den Schritt des Aufdrucks einer Leitschicht (1c, 1d) auf der Innenseite jeder der beiden Gehäuseschalen (1a, 1b), zumindest an den Verbindungsstellen, die zwischen den besagten elektronischen Bauteilen (2, 3, 5, 6, 7, 8) zu errichten sind,
- den Schritt des Aufbringens der Leitschichten (1d, 1c) der besagten Gehäuseschalen (1a, 1b) auf die elektrischen Kontaktlötstellen (9) der elektronischen Bauteile (2, 3, 5, 6, 7, 8), speziell durch Leitkleben oder durch Löten oder durch Hartlöten oder durch Druck,
- den Schritt der Einführung von leitenden Trennelementen (4) zwischen die Leitschichten (1d, 1c), die auf jede der Innenseiten der beiden Gehäuseschalen (1a, 1 b) gedruckt worden sind,

2. Verfahren nach Anspruch 1, wobei die besagte Karte zumindest die folgenden Bauteile enthält:
- eine Batterie (3),
- einen Mikroprozessor (2),
- einen Signalsender (5),
wobei die besagte Batterie (3) und der besagte Signalsender (5) mit dem besagten Mikroprozessor (2) verbunden sind.

3. Verfahren nach Anspruch 2, wobei die besagte Karte darüber hinaus folgendes enthält:
- ein Mikrophon (6), das mit dem Mikroprozessor (2) verbunden ist.

4. Verfahren nach irgendeinem der Ansprüche 2 oder 3, wobei die besagte Karte darüber hinaus folgendes enthält:
- einen Übertragungseingang, im Speziellen eine Antenne (8), die mit dem Mikroprozessor (2) verbunden ist.

5. Verfahren nach irgendeinem der Ansprüche 2 bis 4, wobei die besagte Karte darüber hinaus folgendes enthält:
- einen metallischen Schalenkontakt (7), der mit dem Mikroprozessor (2) verbunden ist.

6. Mobiler elektronischer Gegenstand (1) in Form einer Kreditkarte, wobei der besagte mobile elektronische Gegenstand folgendes enthält:
- elektronische Bauteile (2, 3, 5, 6, 7, 8) mit elektrischen Kontaktlätstellen (9) auf jeder Seite,
- zwei Gehäuseschalen (1a, 1b), zwischen denen die besagten elektronischen Bauteile (2, 3, 5, 6, 7, 8) eingebettet sind,
- eine Leitschicht (1c, 1d), die auf die Innenseite der beiden Gehäuseschalen (1a, 1b) gedruckt sind, zumindest an den Stellen, an denen Verbindungen zwischen den besagten elektronischen Bauteilen (2, 3, 5, 6, 7, 8) aufzubauen sind;
- wobei die besagten Leitschichten (1c, 1d) der besagten Gehäuseschalen (1a, 1b) auf die Kontaktlötstellen (9) der elektronischen Bauteile (2, 3, 5, 6, 7, 8) aufgebracht werden, im Speziellen durch Leitkleben oder durch Löten oder durch Hartlöten oder durch Druck,
- leitende Trennelemente (4), die zwischen die beiden Leitschichten (1d, 1c) eingeschoben werden,

7. Mobiler elektronischer Gegenstand (1) nach Anspruch 6, in Form einer Karte, die akustische Signale sendet, wobei die besagte Karte zumindest folgende Bauteile enthält:
- eine Batterie (3),
- einen Mikroprozessor (2),
- einen Signalsender (5),
wobei die besagte Batterie (3) und der besagte Signalsender (5) über die besagte oder besagten gedruckte(n) Leitschicht(en) (1d, 1c) mit dem besagten Mikroprozessor (2) verbunden sind.

8. Mobiler elektronischer Gegenstand (1) nach Anspruch 7, wobei die besagte Karte darüber hinaus ein Mikrophon (6) enthält, das über die besagte oder besagten gedruckte(n) Leitschicht(en) (1 d, 1c) mit dem Mikroprozessor (2) verbunden ist.

9. Mobiler elektronischer Gegenstand (1) nach irgendeinem der Ansprüche 7 oder 8, wobei die besagte Karte darüber hinaus folgendes enthält:
- einen Übertragungseingang, im Speziellen eine Antenne (8), die mit dem Mikroprozessor (2) verbunden ist.

10. Mobiler elektronischer Gegenstand (1) nach irgendeinem der Ansprüche 7 bis 9, wobei die besagte Karte darüber hinaus einen metallischen Schalenkontakt (7) enthält, der über die besagte oder besagten gedruckte(n) Leitschicht(en) (1d, 1c) mit dem Mikroprozessor (2) verbunden ist.
